# EUROPEAN PATENT APPLICATION

(11) **EP 2 536 024 A1**
(43) Date of publication of application: **19.12.2012**
(21) Application number: 11832078.7
(22) Date of filing: 27.10.2011
(51) Int. Cl.: H03F 1/07

(54) **DOHERTY POWER AMPLIFIER DEVICE AND POWER AMPLIFICATION METHOD THEREFOR**

(30) Priority: 29.04.2011 CN 201110110870
(71) Applicant: ZTE Corporation, 518057 Shenzhen City, Guangdong Province (CN)
(72) Inventor: CHEN, Huazhang, 518057 Shenzhen City Guangdong Province (CN); AN, Jinyuan, 518057 Shenzhen City Guangdong Province (CN); LIU, Jianli, 518057 Shenzhen City Guangdong Province (CN); CUI, Xiaojun, 518057 Shenzhen City Guangdong Province (CN)
(74) Representative: Novagraaf Technologies
(86) International application number: PCT/CN2011/081407
(87) International publication number: WO 2012/146008

(57) **Abstract**

A Doherty power amplifier apparatus and a power amplification method are disclosed in the present invention. The apparatus includes an auxiliary power amplifier apparatus and a main power amplifier apparatus, wherein the auxiliary power amplifier apparatus is configured to amplify signal power by using a Laterally Diffused Metal Oxide Semiconductor (LDMOS) device; the main power amplifier is configured to amplify signal power by using a High voltage heterojunction bipolar transistor (HVHBT) device. An HVHBT device is adopted as a main power amplifier in the present invention. By use of the present invention, a power amplification efficiency of a main power amplifier in a Doherty power amplifier may be enhanced compared with an existing Doherty power amplifier in which both a main power amplifier and an auxiliary power amplifier use LDMOS, thereby a power amplification efficiency of the whole Doherty power amplifier is substantially increased.

## Description

### Technical Field

The present invention relates to the technology field of radio frequency power amplifier design, and particularly to a Doherty power amplifier apparatus and a power amplification method.

### Background of the Related Art

Faced with increasingly fierce competition in the market, efficiency of base station products become an important reference point for competition in the industry, and an enhancement of efficiency of a main component which decides the efficiency as a power amplifier device also becomes a core point, and a lot of human and material resource in the industry is invested in the research of efficiency enhancement technology, and at present, the most widely used technology comprises the Doherty technology, and power amplifier manufacturers have begun mass production and application of the Doherty power amplifiers, thereby how to further improve the efficiency of the technology is particularly important.

The Doherty technology is originally applied in a traveling-wave tube, to provide a high-power transmitter for broadcast, with a simple, easy-to-implement and high efficient architecture.

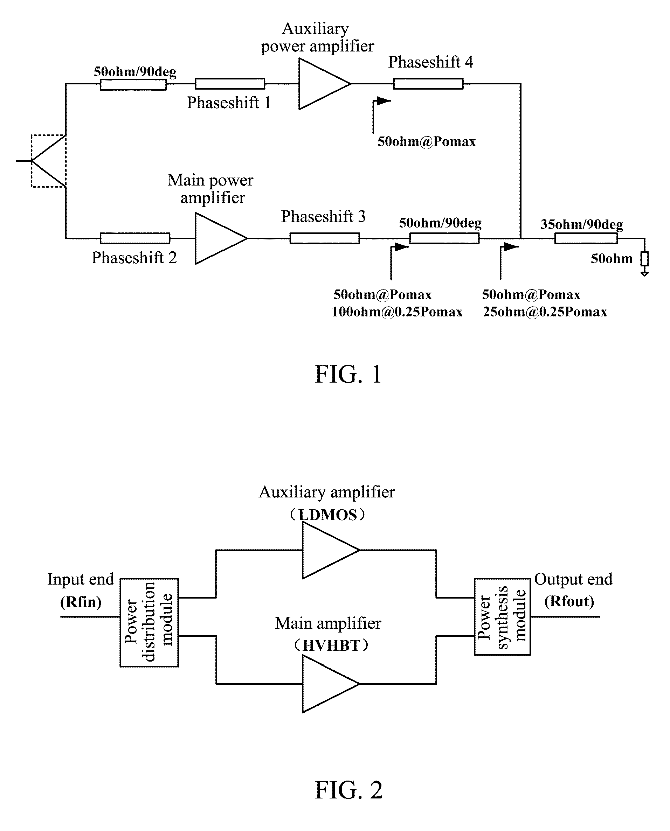

A traditional Doherty structure is composed of two power amplifiers: a main power amplifier (also called as carrier power amplifier), an auxiliary power amplifier (also called as peak power amplifier), wherein the main power amplifier works in class B or class AB, and the auxiliary power amplifier works in class C. The two power amplifiers do not work by turns, in fact the main power amplifier works all the time while the auxiliary power amplifier works at a set peak value (therefore the auxiliary power amplifier is also called as a peak power amplifier). A quarter wavelength line at 90 degrees behind the output end of the main power amplifier plays the role of impedance transformation, whose purpose is to play the role of reducing apparent impedance of the main power amplifier when the auxiliary power amplifier works, thereby ensuring that an active load impedance composed of the main power amplifier and a subsequent circuit becomes lower when the auxiliary power amplifier works, and thus output current of the main power amplifier becomes higher. Because of a quarter wavelength line behind the output end of the main power amplifier, a 90° phase shift is also required in front of the auxiliary power amplifier, in order to make outputs of the two power amplifiers in same phase, as shown in FIG. 1.

The main power amplifier works in class B, and when a total input signal is relatively small, only the main power amplifier is in a working state; when an output voltage of the main power amplifier reaches a peak saturation point, the theoretical efficiency of power amplifier can reach 78.5%. If excitation doubles here, then the saturation will appear when the main power amplifier reaches half of the peak value, and the efficiency of the power amplifier also reaches 78.5%, and now the auxiliary power amplifier also begins to work together with the main power amplifier. An introduction of the auxiliary power amplifier makes the load decrease from the point of view of the main power amplifier, because the function of the auxiliary power amplifier for the load is equivalent to a negative impedance in series, so even though the output voltage of the main power amplifier is saturated and constant, the output power continues to increase because of the decreasing load (current flowing through the load increases). When a peak value of the excitation is reached, the auxiliary power amplifier reaches a maximum point of its own efficiency, such that a combination efficiency of the two power amplifiers is much higher than the efficiency of a single power amplifier of class B. The maximum efficiency 78.5% of a single power amplifier of class B appears at the peak value while now the efficiency 78.5% appears at half of the peak value, so such system structure can bring a higher efficiency (each amplifier can reach the maximum output efficiency).

Both of the main power amplifier and the peak power amplifier (auxiliary power amplifier) of the Doherty amplifier adopt the same type of power amplifier tube, and what is the most common in the industry is a Laterally Diffused Metal Oxide Semiconductor (LDMOS for short) device. By adopting the same type of power amplifier tube, supply voltages and biasing mode of the amplifiers are the same, so that a biasing circuit is easy to be designed; a mass production of the power amplifier tubes is relatively easy to be controlled due to the same type. Mainstream LDMOS devices in the industry have developed to the 8th generation with a low cost, however, the room of improvement of performance is very limited, which can not satisfy the requirements of environment protection meanwhile.

### Summary of the Invention

The technical problem to be solved by the present invention is to provide a Doherty power amplifier apparatus and a power amplification method, to enhance power amplification efficiency of the Doherty power amplifier apparatus.

In order to solve the above technical problem, the present invention provides a Doherty power amplifier apparatus, comprising an auxiliary power amplifier apparatus and a main power amplifier apparatus, wherein,
the auxiliary power amplifier apparatus is configured to use a Laterally Diffused Metal Oxide Semiconductor (LDMOS) device to amplify signal power;
the main power amplifier apparatus is configured to use a High Voltage Heterojunction Bipolar Transistor (HVHBT) device to amplify signal power.

The above Doherty power amplifier apparatus may also have the following characteristic of:
the HVHBT device being a GaAs-based device.

In order to solve the above technical problem, the present invention also provides a power amplification method, comprising:
in a Doherty power amplifier apparatus, using a Laterally Diffused Metal Oxide Semiconductor (LDMOS) device to amplify signal power of an auxiliary power amplifier apparatus, and using a High Voltage Heterojunction Bipolar Transistor (HVHBT) device to amplify signal power of a main power amplifier apparatus.

The above method may also have the following characteristic of:
the HVHBT device being a GaAs-based device.

The above method may also have the following characteristic of:
selecting the HVHBT device according to power amplification parameters of the Doherty power amplifier apparatus.

In order to solve the above technical problem, the present invention also provides a main power amplifier apparatus, applied in a Doherty power amplifier apparatus, characterized in that
the main power amplifier apparatus is configured to use a High Voltage Heterojunction Bipolar Transistor (HVHBT) device to amplify signal power.

The above main power amplifier apparatus may also have the following characteristic of:
the HVHBT device being a GaAs-based device.

In order to solve the above technical problem, the present invention also provides a power amplification method, comprising:
in a Doherty power amplifier apparatus, using a High Voltage Heterojunction Bipolar Transistor (HVHBT) device to amplify signal power of a main power amplifier apparatus.

The above method may also have the following characteristic of:
the HVHBT device being a GaAs-based device.

The above method may also have the following characteristic of:
selecting the HVHBT device according to power amplification parameters of the Doherty power amplifier apparatus.

An HVHBT device is adopted as a main power amplifier according to the above scheme, therefore a power amplification efficiency of a main power amplifier in the Doherty power amplifier can be enhanced, compared with an existing Doherty power amplifier in which both a main power amplifier and an auxiliary power amplifier use LDMOS, thereby a power amplification efficiency of the whole Doherty power amplifier may increase substantially.

Since the cost of the current GaAs-based HVHBT power amplifier tube is 2-3 times higher than that of a LDMOS device based on Si, the cost of the above method and apparatus will be reduced greatly and the performance thereof will be enhanced compared with the Doherty power amplifier in which both a main power amplifier and an auxiliary power amplifier use the GaAs power amplifier tube.

In addition, since LDMOS is developed very maturely, there are a variety of products of each manufacturer and many types of products with different frequency bands and different power levels, and LDMOS products of different model numbers may be used as auxiliary amplifiers during application according to different power levels, in combination with main amplifiers using GaAs power amplifier tubes flexibly, and different Doherty structures (symmetrical structure, asymmetrical structure, multichannel structure and so on) are adopted for implementation as required, which takes the cost and performance into account and ensures ease of use and flexibility.

### Brief Description of Drawings

FIG. 1 is a structural diagram of a traditional Doherty power amplifier;
FIG. 2 is a structural diagram of a Doherty power amplifier with a two-channel structure according to an embodiment;

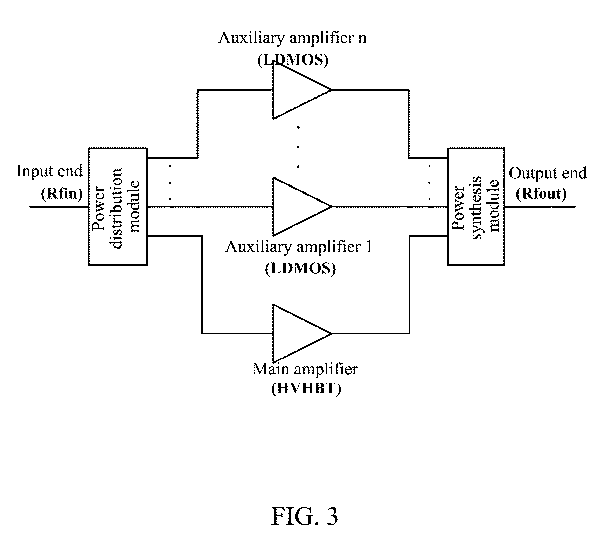

FIG. 3 is a structural diagram of a Doherty power amplifier with a multichannel structure according to an embodiment.

### Preferred Embodiments of the Present Invention

From a view of signal power spectrum distribution of different standards in the current communication system, 70%-80% of energy output by a power amplifier is concentrated about the average power, that is, most of the working current of the power amplifier is contributed by a main power amplifier, therefore a enhancement of the efficiency of a main power amplifier is of great significance in enhancement of the efficiency of the whole power amplifier.

A main power amplifier apparatus in Doherty power amplifier according to embodiments of the present invention is configured to use a High Voltage Heterojunction Bipolar Transistor (called as HVHBT for short) device to amplify signal power.

The HVHBT device refers to an HBT technology device that can works under a high voltage, and the high voltage refers to a working voltage over 12V. It includes but not limited to a Tripower series of power amplifier devices of Triquint Company in America.

A corresponding power amplification method comprises: in a Doherty power amplifier apparatus, using a HVHBT device to amplify signal power of a main power amplifier apparatus.

Alternatively, the HVHBT device is a GaAs-based device.

Alternatively, the HVHBT device is selected according to power amplification parameters of the Doherty power amplifier apparatus. The power amplification parameters of the Doherty power amplifier apparatus comprise: working frequency, power value and peak-to-average ratio, and so on.

The Doherty power amplifier apparatus according to embodiments of the present invention comprises an auxiliary power amplifier apparatus and a main power amplifier apparatus. The auxiliary power amplifier apparatus is configured to use a LDMOS device to amplify signal power; the main power amplifier apparatus is configured to use a HVHBT device to amplify signal power.

A corresponding power amplification method comprises: in a Doherty power amplifier apparatus, using a LDMOS device to amplify signal power of an auxiliary power amplifier apparatus, and using a HVHBT device to amplify signal power of a main power amplifier apparatus.

Alternatively, the HVHBT device is a GaAs-based device.

For a two-channel Doherty power amplifier (including a traditional symmetrical Doherty structure with two channels, an asymmetrical Doherty structure) and an evolved structure including a main amplifier and an auxiliary amplifier on the basis of the two-channel Doherty power amplifier, a HVHBT power amplifier tube works as a main amplifier, and a LDMOS power amplifier tube works as an auxiliary amplifier.

For a multichannel Doherty power amplifier and an evolved structure including a main amplifier and multiple auxiliary amplifiers on the basis of the multichannel Doherty power amplifier, a HVHBT power amplifier tube works as a main amplifier and a LDMOS power amplifier tube works as an auxiliary amplifier.

The HVHBT device is selected according to power amplification parameters of the Doherty power amplifier apparatus. The power amplification parameters of the Doherty power amplifier apparatus comprise: working frequency, power value and peak-to-average ratio, and so on.

During the design of Doherty power amplifier, the model number of HVHBT power amplifier tube used as a main amplifier is determined according to the required power amplification parameters; the structure of a Doherty power amplifier is determined (two-channel structure or a multichannel structure), and the model number of LDMOS power amplifier tube used by an auxiliary amplifier is determined; the matching design of the amplifiers and the design of parts of power distribution and power synthesis in a block diagram are completed; the design of remaining parts of Doherty power amplifier is completed.

A Doherty power amplifier apparatus applied in embodiments of the present invention comprises a power distribution module and a power synthesis module, wherein the power distribution module is responsible for a function of distributing input signals to a main power amplifier and an auxiliary power amplifier respectively, and regarding to a traditional Doherty power amplifier as shown in FIG. 1, the power distribution module comprises a component part between input ends of auxiliary power amplifier and main power amplifier and an input end of a whole Doherty power amplifier. The power synthesis module is responsible for a function of combining an amplified signal output by the main power amplifier and an amplified signal of the auxiliary power amplifier; regarding to a traditional Doherty power amplifier as shown in FIG. 1, the power synthesis module comprises a component part between output ends of auxiliary power amplifier and main power amplifier and an output end (RFout) of a whole Doherty power amplifier. The power distribution module and the power synthesis module are not limited to the structure of the traditional Doherty power amplifier as shown in FIG. 1, and they respectively corresponds to a circuit layout that executes a corresponding power distribution function and a circuit layout that executes a corresponding power synthesis function in a Doherty power amplifier with other structure applicable to embodiments of the present invention.

Specific application examples:
For the Doherty power amplifier design with power of 55W and a peak-to-average ratio of 6dB applied in the 2.1 GHz UMTS system, two power amplifier tubes with saturation power of totaling at least 200W are required. In combination with existing devices of power amplifier tube manufacturers, it may be implemented by using two LDMOS power amplifier tubes with power of 120W respectively through a symmetrical Doherty structure, and single and final power amplifier efficiency thereof is about 52% according to a current level of device in the industry. And in the implementation of method according to embodiments of the present invention, a main amplifier uses a HVHBT power amplifier tube with power of 120W, and an auxiliary amplifier uses a LDMOS power amplifier tube with power of 120W, and then the single and final power amplifier efficiency thereof is about 57%, enhancing the power amplification efficiency. If both the main amplifier and the auxiliary amplifier use an HVHBT power amplifier tube, the single and final power amplifier efficiency thereof is still about 57%, but the cost will be about 3 times higher than the implementation of the method based on embodiments of the present invention.

A breakthrough and new combination mode is adopted in the embodiment of present invention, making full use of the advantage of high efficiency of an HVHBT power amplifier tube which works as a main amplifier to enhance the efficiency and has an optimal implementation performance; meanwhile by way of making use of advantages of the LDMOS power amplifier tube such as higher technology maturity, lower cost and all device types, the LDMOS power amplifier tube works as an auxiliary amplifier to have an optimal implementation cost, and a perfect combination of performance and cost is finally implemented. An efficiency indicator of the Doherty power amplifier could be enhanced significantly within its working frequency band range, and the apparatus can be widely applied in designs of various Doherty power amplifiers.

It should be noted that, in the case without conflicts, embodiments in the application and characteristics in the embodiments can be combined with each other at random.

Of course, there may be many other embodiments of the present invention, and those skilled in the art may make various corresponding changes and variations according to the present invention without departing from the spirit and substance of the present invention, however, these corresponding changes and variations should fall into the protection scope of appended claims of the present invention.

The ordinary person skilled in the art should understand that the all or part of steps of the above-mentioned method may be completed by program instructing relevant hardware, and the program may be stored in a computer readable storage medium such as a read only memory, a magnetic disk or a compact disk and so on. Alternatively, all or part of steps of the above-mentioned embodiments may also be implemented by using one or more integrated circuits. Correspondingly, each module/unit in the above-mentioned embodiments may be implemented in the form of hardware, or may be implemented in the form of software function module. The present invention is not limited to any specified form of the combination of hardware and software.

### Industrial Applicability

Compared with an existing Doherty power amplifier in which both a main power amplifier and an auxiliary power amplifier use LDMOS, amplification efficiency of a main power amplifier in a Doherty power amplifier may be enhanced according to the above embodiments and thereby the amplification efficiency of the whole Doherty power amplifier may be enhanced substantially, which enhances the performance and meanwhile reduces the cost greatly, and takes the cost and performance into account and meanwhile ensures ease of use and flexibility.

## Claims

1. A Doherty power amplifier apparatus, comprising an auxiliary power amplifier apparatus and a main power amplifier apparatus, wherein,
the auxiliary power amplifier apparatus is configured to use a Laterally Diffused Metal Oxide Semiconductor (LDMOS) device to amplify signal power;
the main power amplifier apparatus is configured to use a High Voltage Heterojunction Bipolar Transistor (HVHBT) device to amplify signal power.

2. The Doherty power amplifier apparatus according to claim 1, wherein,
the HVHBT device is a GaAs-based device.

3. A power amplification method, comprising:
in a Doherty power amplifier apparatus, using a Laterally Diffused Metal Oxide Semiconductor (LDMOS) device to amplify signal power of an auxiliary power amplifier apparatus, and using a High Voltage Heterojunction Bipolar Transistor (HVHBT) device to amplify signal power of a main power amplifier apparatus.

4. The method according to claim 3, wherein,
the HVHBT device is a GaAs-based device.

5. The method according to claim 3, further comprising:
selecting the HVHBT device according to power amplification parameters of the Doherty power amplifier apparatus.

6. A main power amplifier apparatus, applied in a Doherty power amplifier apparatus, wherein,
the main power amplifier apparatus is configured to use a High Voltage Heterojunction Bipolar Transistor (HVHBT) device to amplify signal power.

7. The main power amplifier apparatus according to claim 6, wherein,
the HVHBT device is a GaAs-based device.

8. A power amplification method, comprising:
in a Doherty power amplifier apparatus, using a High Voltage Heterojunction Bipolar Transistor (HVHBT) device to amplify signal power of a main power amplifier apparatus.

9. The method according to claim 8, wherein,
the HVHBT device is a GaAs-based device.

10. The method according to claim 8, further comprising:
selecting the HVHBT device according to power amplification parameters of the Doherty power amplifier apparatus.
